(19) Europäisches Patentamt
European Patent Office
Office européen des brevets

(11) **EP 4 611 007 A1**

(12) **EUROPEAN PATENT APPLICATION**
published in accordance with Art. 153(4) EPC

(43) Date of publication:
**03.09.2025 Bulletin 2025/36**

(21) Application number: **23882730.7**

(22) Date of filing: **26.10.2023**

(51) International Patent Classification (IPC):
***H01B 12/06*** (2006.01)

(52) Cooperative Patent Classification (CPC):
**H01B 12/06**

(86) International application number:
**PCT/JP2023/038746**

(87) International publication number:
**WO 2024/090528 (02.05.2024 Gazette 2024/18)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **27.10.2022 JP 2022172013**

(71) Applicant: **Fujikura Ltd.
Tokyo 135-8512 (JP)**

(72) Inventors:
• **NAKAMURA Naonori
Sakura-shi, Chiba 285-8550 (JP)**
• **KIKUTAKE Ryo
Sakura-shi, Chiba 285-8550 (JP)**

(74) Representative: **Plasseraud IP
104 Rue de Richelieu
CS92104
75080 Paris Cedex 02 (FR)**

(54) **OXIDE SUPERCONDUCTOR WIRE MATERIAL, SUPERCONDUCTOR COIL, AND
SUPERCONDUCTOR**

(57) An oxide superconducting wire includes a tape-shaped metal substrate made of a nickel alloy, an intermediate layer laminated on the metal substrate, and an oxide superconducting layer laminated on the intermediate layer, in which an average crystal grain size of the metal substrate is 3.08 $\mu$m or more and is equal to or less than a thickness of the metal substrate.

FIG. 1

**Description**

TECHNICAL FIELD

The present invention relates to an oxide superconducting wire, a superconducting coil, and a superconductor.
Priority is claimed on Japanese Patent Application No. 2022-172013, filed October 27, 2022, the content of which is incorporated herein by reference.

BACKGROUND ART

Patent Document 1 discloses an oxide superconducting wire including a tape-shaped metal substrate, an intermediate layer laminated on the metal substrate, and an oxide superconducting layer laminated on the intermediate layer.

Citation List

Patent Document

Patent Document 1: Japanese Unexamined Patent Application, First Publication No. 2020-166983

SUMMARY OF INVENTION

Technical Problem

In the related art, there has been a problem in that characteristics of an oxide superconducting wire deteriorate when an excessive tensile stress is applied to the oxide superconducting wire in a longitudinal direction. In general, an oxide superconducting layer has higher rigidity than a metal substrate and is less susceptible to elongation deformation. Therefore, when an excessive tensile stress is applied to the oxide superconducting wire in the longitudinal direction, the oxide superconducting layer cannot withstand elongation deformation of the metal substrate, and cracks may occur in the oxide superconducting layer. Resistance increases in a portion where cracks occur, which causes a problem in that superconducting characteristics of the oxide superconducting layer deteriorate.
The present invention has been made in consideration of such circumstances, and an object of the present invention is to provide an oxide superconducting wire, a superconducting coil, and a superconductor, in which superconducting characteristics are less likely to deteriorate even when a tensile stress is applied.

Solution to Problem

In order to solve the above-described problem, according to Aspect 1 of the present invention, there is provided an oxide superconducting wire including a tape-shaped metal substrate made of a nickel alloy, an intermediate layer laminated on the metal substrate, and an oxide superconducting layer laminated on the intermediate layer, in which an average crystal grain size of the metal substrate is 3.08 $\mu$m or more and is equal to or less than a thickness of the metal substrate.
According to Aspect 1 of the present invention, it is possible to achieve an oxide superconducting wire having a high allowable strain amount in $LN_2$, that is, having a low possibility of deterioration of superconducting characteristics even when a tensile stress is applied.
In addition, according to Aspect 2 of the present invention, in the oxide superconducting wire according to Aspect 1, a standard deviation of a crystal grain size of the metal substrate is in a range of 2.32 to 14.66 $\mu$m.
According to Aspect 2 of the present invention, it is possible to achieve an oxide superconducting wire having a metal substrate in which recrystallization has not progressed much and having high tensile resistance.
In addition, according to Aspect 3 of the present invention, in the oxide superconducting wire according to Aspect 1 or Aspect 2, the average crystal grain size is an average value of crystal grain sizes in a cross section of the metal substrate along a longitudinal direction and a thickness direction.
In addition, according to Aspect 4 of the present invention, in the oxide superconducting wire according to any one of Aspect 1 to Aspect 3, the average crystal grain size is an average value of crystal grain sizes measured by a reflection EBSD method.
In addition, according to Aspect 5 of the present invention, there is provided a superconducting coil formed by winding the oxide superconducting wire according to any one of Aspect 1 to Aspect 4.
In addition, according to Aspect 6 of the present invention, a superconductor formed by assembling a plurality of the oxide superconducting wires is provided according to any one of Aspect 1 to Aspect 4.

Advantageous Effects of Invention

According to the aspects of the present invention, it is possible to provide an oxide superconducting wire, a superconducting coil, and a superconductor, in which superconducting characteristics are less likely to deteriorate even when a tensile stress is applied.

BRIEF DESCRIPTION OF DRAWINGS

[FIG. 1] A cross-sectional view showing an oxide superconducting wire according to an embodiment of the present invention.
[FIG. 2] A diagram showing a relationship between an average crystal grain size of a metal substrate and an allowable strain amount in $LN_2$>
[FIG. 3] A perspective view of a superconducting coil formed of the oxide superconducting wire of FIG. 1.
[FIG. 4A] A diagram showing a superconductor formed of the oxide superconducting wire of FIG. 1.
[FIG. 4B] A diagram showing another example of the superconductor formed of the oxide superconducting wire of FIG. 1.
[FIG. 4C] A diagram showing still another example of the superconductor formed of the oxide superconducting wire of FIG. 1.

DESCRIPTION OF EMBODIMENTS

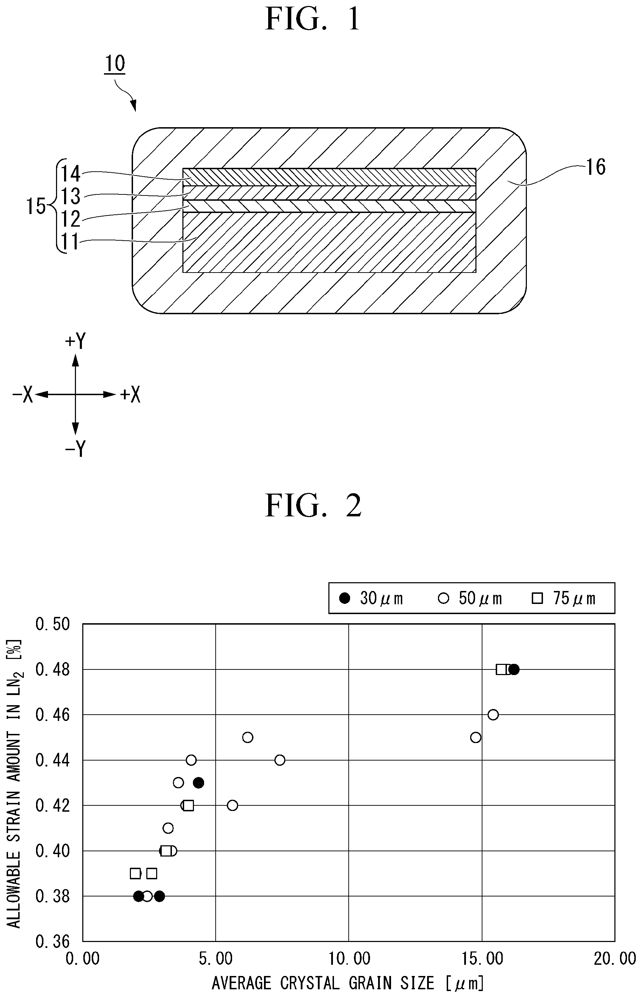

Hereinafter, an oxide superconducting wire according to an embodiment of the present invention will be described with reference to the accompanying drawings.
As shown in FIG. 1, an oxide superconducting wire 10 according to the present embodiment includes a metal substrate 11, an intermediate layer 12, an oxide superconducting layer 13, a protective layer 14, and a stabilization layer 16. Hereinafter, the metal substrate 11, the intermediate layer 12, the oxide superconducting layer 13, and the protective layer 14 may be collectively referred to as a "superconductor laminate 15".
Each of the metal substrate 11, the intermediate layer 12, the oxide superconducting layer 13, and the protective layer 14 is formed in a tape shape. The metal substrate 11, the intermediate layer 12, the oxide superconducting layer 13, and the protective layer 14 are laminated in this order in a thickness direction of the metal substrate 11 (a thickness direction of the oxide superconducting wire 10). The stabilization layer 16 covers an outer periphery of the superconductor laminate 15. The oxide superconducting wire 10 has a tape shape.

(Definition of Direction)

Here, in the present embodiment, an XYZ Cartesian coordinate system is set and a positional relationship of each configuration will be described. AThe Z-axis direction (not shown) is a direction along a longitudinal direction of the oxide superconducting wire 10. A Y-axis direction is a direction perpendicular to the Z-axis direction, and is a direction along the thickness direction of the oxide superconducting wire 10. The Y-axis direction is also a direction in which the layers 11 to 14 of the superconductor laminate 15 are laminated. An X-axis direction is a direction perpendicular to both the Z-axis direction and the Y-axis direction, and is a direction along a width direction of the oxide superconducting wire 10. In the present specification, the X-axis direction may be referred to as a width direction X, the Y-axis direction may be referred to as a thickness direction Y, and the Z-axis direction may be referred to as a longitudinal direction Z. In addition, a direction from the metal substrate 11 toward the oxide superconducting layer 13 along the thickness direction Y is referred to as a +Y direction or upward. A direction opposite to the +Y direction is referred to as a -Y direction or downward. One direction along the width direction X is referred to as a +X direction or rightward. A direction opposite to the +X direction is referred to as a -X direction or leftward.
Specific examples of metal constituting the metal substrate 11 include a nickel alloy represented by HASTELLOY (registered trademark). A thickness of the metal substrate 11 need only be adjusted as appropriate for the purpose, and is, for example, in a range of 10 to 1000 $\mu$m.
The intermediate layer 12 is laminated on the metal substrate 11 (an upper surface of the metal substrate 11). The configuration of the intermediate layer 12 is not limited to the example of FIG. 1. For example, the intermediate layer 12 may have a multilayer structure. In this case, the intermediate layer 12 may have, in order from the metal substrate 11 toward the oxide superconducting layer 13, a diffusion prevention layer, a bed layer, an orientation layer, a cap layer, and the like.

These layers are not all necessarily provided. Some of the layers may be omitted, or two or more layers of the same type may be included. The intermediate layer 12 may be a metal oxide. By forming the oxide superconducting layer 13 on an upper surface of the intermediate layer 12 having exceptional orientation, the oxide superconducting layer 13 having exceptional orientation can be easily obtained.

The oxide superconducting layer 13 is laminated on the intermediate layer 12 (on the upper surface of the intermediate layer 12). The oxide superconducting layer 13 is made of an oxide superconductor. Examples of the oxide superconductor constituting the oxide superconducting layer 13 include an RE-Ba-Cu-O-based oxide superconductor (REBCO-based oxide superconductor) represented by a general formula $RE_1Ba_2Cu_3O_y$ (RE123) or the like. As a rare earth element RE, one or more of Y, La, Ce, Pr, Nd, Sm, Eu, Gd, Tb, Dy, Ho, Er, Tm, Yb, and Lu are exemplary examples. In the general formula of RE123, y is 7-x (oxygen deficiency amount x: approximately 0 to 1). In addition, a ratio of RE:Ba:Cu is not limited to 1:2:3, and may be non-stoichiometric. A thickness of the oxide superconducting layer 13 is, for example, in a range of 0.5 to 5 $\mu$m. The oxide superconducting layer 13 can be formed by a pulsed laser ablation (PLD) film deposition method or the like.

Artificial pins made of different types of materials may be introduced into the oxide superconducting layer 13 as artificial crystal defects. As the different types of materials used for introducing the artificial pins into the oxide superconducting layer 13, at least one or more of $BaSnO_3$ (BSO), $BaZrO_3$ (BZO), $BaHfO_3$ (BHO), $BaTiO_3$ (BTO), $SnO_2$, $TiO_2$, $ZrO_2$, $LaMnO_3$, ZnO, and the like are exemplary examples.

The protective layer 14 is laminated on the oxide superconducting layer 13 (an upper surface of the oxide superconducting layer 13). The protective layer 14 has a function of bypassing an overcurrent generated in an event of an accident or suppressing a chemical reaction occurring between the oxide superconducting layer 13 and a layer provided on the protective layer 14. As the material of the protective layer 14, silver (Ag), copper (Cu), gold (Au), an alloy of gold and silver, other silver alloys, copper alloys, and gold alloys are exemplary examples. A thickness of the protective layer 14 is, for example, in a range of 1 to 30 $\mu$m. The protective layer 14 may be composed of two or more metals or two or more metal layers. The protective layer 14 can be formed by a vapor deposition method, a sputtering method, or the like.

The stabilization layer 16 is formed around the entire periphery of the superconductor laminate 15. In other words, the stabilization layer 16 covers an upper surface, a lower surface, and a pair of side surfaces of the superconductor laminate 15. In the present embodiment, the phrase "upper surface of the superconductor laminate 15" corresponds to an upper surface of the protective layer 14, the phrase "lower surface of the superconductor laminate 15" corresponds to a lower surface of the metal substrate 11, and the phrase "side surfaces of the superconductor laminate 15" corresponds to side surfaces of each of the layers 11 to 14. The stabilization layer 16 has a function of bypassing an overcurrent generated in an event of an accident or mechanically reinforcing the oxide superconducting layer 13 and the protective layer 14. The stabilization layer 16 is made of, for example, a copper (Cu) plating layer. A thickness of the stabilization layer 16 is not particularly limited, but is, for example, in a range of 1 to 300 $\mu$m.

In general, an oxide superconducting layer has higher rigidity than a metal substrate and is less susceptible to elongation deformation. Therefore, when an excessive tensile stress is applied to the oxide superconducting wire in the longitudinal direction, the oxide superconducting layer cannot withstand elongation deformation of the metal substrate, and cracks may occur in the oxide superconducting layer. Resistance increases in a portion where cracks occur, which causes a problem in that superconducting characteristics of the oxide superconducting layer deteriorate.

The inventors of the present application intensively studied this problem, and as a result, it was found that, by appropriately setting an average crystal grain size of the metal substrate 11, it is possible to suppress the deterioration of the superconducting characteristics when a tensile stress is applied. An appropriate value of the average crystal grain size of the metal substrate 11 will be described below using specific examples. The present invention is not limited to the examples below.

Examples

Oxide superconducting wires of Comparative Examples 1 to 6 and Examples 1 to 18 were produced. These oxide superconducting wires have a metal substrate 11 having a thickness of 30 $\mu$m, 50 $\mu$m, or 75 $\mu$m, and an average crystal grain size of the metal substrate 11 in each oxide superconducting wire is different. Table 1 shows the thickness and the average crystal grain size of the metal substrate 11 of the oxide superconducting wire 10. Conditions other than the thickness and the average crystal grain size of the metal substrate 11 are common among a plurality of the oxide superconducting wires 10 thus produced as follows. The average crystal grain size of the metal substrate 11 can be adjusted by adjusting conditions (temperature, crystal grain size of the substrate before rolling, and the like) when rolling the metal substrate 11 and conditions (temperature, time, and the like) when forming the intermediate layer 12 and the oxide superconducting layer 13.

Material of metal substrate 11: HASTELLOY
Width of metal substrate 11: 4 mm

Material of oxide superconducting layer 13: EuBCO + BHO
Thickness of oxide superconducting layer 13: 2 $\mu$m
Method of forming oxide superconducting layer 13: PLD film deposition
Material of protective layer 14: Ag
Thickness of protective layer 14: 2 $\mu$m
Method of forming protective layer 14: sputtering
Material of stabilization layer 16: Cu
Thickness of stabilization layer 16: 5 $\mu$m
Method of forming stabilization layer 16: plating
As the intermediate layer 12, a commonly used one was adopted.

Table 1 summarizes results of measuring the average crystal grain size of the metal substrate 11, a standard deviation of the crystal grain size of the metal substrate 11, and an allowable strain amount (details will be described below) in $LN_2$ for each of the oxide superconducting wires of Comparative Examples 1 to 6 and Examples 1 to 18. In Table 1, the tensile resistance was determined to be "pass" when the allowable strain amount in $LN_2$ was 0.40% or more, and the tensile resistance was determined to be "fail" when the allowable strain amount in $LN_2$ was less than 0.40%. FIG. 2 is a graph showing a relationship between the average crystal grain size of the metal substrate 11 and the allowable strain amount in $LN_2$.

[Table 1]

| Example or Comparative Example | Substrate thickness [$\mu$m] | Average crystal grain size [$\mu$m] | Standard deviation of crystal grain size | Allowable strain amount in $LN_2$ [%] | Tensile stress |
|---|---|---|---|---|---|
| Comparative Example 1 | 50 | 2.01 | 1.99 | 0.39 | Fail |
| Comparative Example 2 | 50 | 2.42 | 2.10 | 0.38 | Fail |
| Comparative Example 3 | 30 | 2.10 | 2.03 | 0.38 | Fail |
| Comparative Example 4 | 30 | 2.88 | 2.26 | 0.38 | Fail |
| Comparative Example 5 | 75 | 1.98 | 1.89 | 0.39 | Fail |
| Comparative Example 6 | 75 | 2.60 | 2.18 | 0.39 | Fail |
| Example 1 | 50 | 3.08 | 2.32 | 0.40 | Pass |
| Example 2 | 50 | 3.21 | 2.92 | 0.41 | Pass |
| Example 3 | 50 | 3.35 | 2.76 | 0.40 | Pass |
| Example 4 | 50 | 3.60 | 3.45 | 0.43 | Pass |
| Example 5 | 50 | 3.88 | 3.97 | 0.42 | Pass |
| Example 6 | 50 | 4.08 | 3.01 | 0.44 | Pass |
| Example 7 | 50 | 5.63 | 3.60 | 0.42 | Pass |
| Example 8 | 50 | 6.20 | 3.89 | 0.45 | Pass |
| Example 9 | 50 | 7.41 | 4.23 | 0.44 | Pass |
| Example 10 | 50 | 14.77 | 12.74 | 0.45 | Pass |
| Example 11 | 50 | 15.42 | 13.16 | 0.46 | Pass |
| Example 12 | 50 | 15.98 | 14.66 | 0.48 | Pass |
| Example 13 | 30 | 3.14 | 2.49 | 0.40 | Pass |
| Example 14 | 30 | 4.35 | 3.88 | 0.43 | Pass |
| Example 15 | 30 | 16.20 | 14.46 | 0.48 | Pass |
| Example 16 | 75 | 3.13 | 2.45 | 0.40 | Pass |
| Example 17 | 75 | 3.97 | 3.79 | 0.42 | Pass |
| Example 18 | 75 | 15.73 | 14.50 | 0.48 | Pass |

# EP 4 611 007 A1

The allowable strain amount in LN$_2$ is a parameter indicating the resistance of the oxide superconducting wire to a tensile stress. Specifically, the allowable strain amount in LN$_2$ is defined as the maximum strain amount among strain amounts at which the characteristics (superconducting characteristics) as the oxide superconducting wire are maintained. Here, the strain amount is a parameter representing an elongation rate of the oxide superconducting wire, and is defined by the following equation, where L$_0$ is a natural length of the oxide superconducting wire and L$_1$ is a length of the oxide superconducting wire in a stretched state.

$$\text{Strain amount [\%]} = 100 \times (L_1 - L_0)/L_0$$

Whether or not the superconducting characteristics are maintained is determined by a value of a ratio (Ic$_1$/Ic$_0$) of a critical current value Ic$_0$ when the oxide superconducting wire is at its natural length to a critical current value Ic$_1$ when the oxide superconducting wire is stretched. When the value of Ic$_1$/Ic$_0$ is 0.95 or more, it is determined that "the characteristics are maintained", and, when the value of Ic$_1$/Ic$_0$ is less than 0.95, it is determined that "the characteristics are not maintained".

In addition, the average crystal grain size of the metal substrate 11 in the produced oxide superconducting wire was calculated as an average value of crystal grain sizes measured by a reflection electron backscattering diffraction (EBSD) method. Observation conditions for a sample in the EBSD method are as follows.

Acceleration voltage: 15 kV
Irradiation current: 15 nA
Sample tilt angle: 70°
The number of sample observation points: any one point
Interval: 150 nm/step

A sample observation range was set to 45 × 45 μm in Comparative Examples 1 and 2 and Examples 1 to 12 in which the substrate thickness was 50 μm, was set to 25 × 25 μm in Comparative Examples 3 and 4 and Examples 13 to 15 in which the substrate thickness was 30 μm, and was set to 70 × 70 μm in Comparative Examples 5 and 6 and Examples 16 to 18 in which the substrate thickness was 75 μm.

In addition, when measuring the crystal grain size using the reflection EBSD method, the crystal grain size was defined as a grain size of a crystal grain obtained when a crystal orientation angle difference was 5° or more and a Σ3 twin boundary was used as a grain boundary. In addition, a region having low reliability in crystal orientation attribution of a reflection EBSD pattern was excluded, and a region having a reliability parameter confidence index (CI) value of 0.1 or more was adopted. Specifically, in measuring the crystal grain size of the metal substrate 11, a cross-sectional specimen of the metal substrate 11 along the longitudinal direction and the thickness direction was produced by mechanical polishing and Ar ion milling, and the cross-sectional specimen was observed and measured. The crystal grain size was observed using a thermal field emission scanning electron microscope (TFE-SEM) JSM-6500F manufactured by JEOL Ltd. In addition, an area-average grain size weighted by an area ratio of each of the observed crystal sizes to the entire field of view was defined as the average crystal grain size.

The reason why the tensile resistance was determined to be "pass" or "fail" depending on whether or not the allowable strain amount in LN$_2$ was 0.40% or more is as follows.

In general, in a superconducting coil or the like, a tensile stress caused by an electromagnetic force of the superconducting coil is applied to the oxide superconducting wire. The oxide superconducting wire is required to maintain its superconducting characteristics even when a tensile stress caused by this electromagnetic force is applied thereto. The inventors of the present application have examined an oxide superconducting wire that experienced degradation of its characteristics after being coiled and an oxide superconducting wire that did not experience degradation of its characteristics even after being coiled, and as a result, it was found that whether the degradation of the characteristics occurred or not is determined by the allowable strain amount of 0.40% in LN$_2$. Therefore, in the present embodiment, it is determined whether the tensile resistance is "pass" or "fail" depending on whether or not the allowable strain amount in LN$_2$ is 0.40% or more.

As shown in FIG. 2 and Table 1, the larger the average crystal grain size of the metal substrate 11, the larger the allowable strain amount in LN$_2$. In addition, in Examples 1 to 18 in which the average crystal grain size of the metal substrate 11 was 3.08 μm or more, the determination result of the tensile resistance was "pass", and, in Comparative Examples 1 to 6 in which the average crystal grain size of the metal substrate 11 was less than 3.08 μm, the determination result of the tensile resistance was "fail". In addition, as shown in Table 1, the standard deviation of the crystal grain size of the metal substrate 11 was larger in Examples 1 to 18 in which the determination result of the tensile resistance was "pass" than in Comparative Examples 1 to 6 in which the determination result of the tensile resistance was "fail". Hereinafter, these results will be discussed.

6

In general, the smaller the average crystal grain size of a metal solid, the smaller the strain amount in the metal solid as a whole, and the larger the average crystal grain size, the larger the strain amount in the metal solid as a whole. However, the smaller the average crystal grain size, the larger the variation in the strain amount in the metal solid, and the more likely it is for a specifically and largely strained portion to occur. On the contrary, the larger the average crystal grain size, the smaller the variation in the strain amount in the metal solid, and the less likely it is for a specifically and largely strained portion to occur.

Similarly, in the metal substrate 11 having a small average crystal grain size, the strain amount of the metal substrate 11 as a whole is small when a tensile stress is applied, but it is considered that a specifically and largely strained portion is likely to occur. This is considered to be because a site where a solute element is fixed to a movable dislocation appears in a process of the crystal grain size being refined, resulting in formation of a site where the strain amount is small and a site where the strain amount is large. In addition, it is considered that cracks occur in the oxide superconducting layer 13 at the largely strained portion, causing deterioration in the superconducting characteristics. On the other hand, in the metal substrate 11 having a large average crystal grain size, although the strain amount of the metal substrate 11 as a whole increases when a tensile stress is applied, it is considered that a specifically and largely strained portion is less likely to occur. Therefore, it is considered that cracks are less likely to occur in the oxide superconducting layer 13, and the superconducting characteristics are secured. Accordingly, it is concluded that the larger the average crystal grain size of the metal substrate 11, the larger the tensile resistance (the allowable strain amount in $LN_2$). Then, from the above consideration, even when the average crystal grain size of the metal substrate 11 is larger than 16.20 $\mu$m (Example 15), the allowable strain amount in $LN_2$ is expected to be similarly large.

In addition, in a step of forming the intermediate layer 12 or the oxide superconducting layer 13, high heat is applied to the metal substrate 11. This heat causes recrystallization of the metal contained in the metal substrate 11. In general, since the crystal grain size of the rolled metal decreases when the rolled metal is recrystallized, it is desirable that the recrystallization does not proceed from the viewpoint of increasing the allowable strain amount in $LN_2$. When the recrystallization has progressed to a nearly complete state, most of the crystal grains present in the metal substrate 11 have a small size, so that the standard deviation of the crystal grain size becomes small. On the contrary, when the recrystallization has not progressed much, the crystal grains having a small size and the crystal grains having a large size are mixed in the metal substrate 11, so that the standard deviation of the crystal grain size becomes large. Therefore, the fact that the standard deviation of the crystal grain size of the metal substrate 11 is large means that the recrystallization of the metal contained in the metal substrate 11 has not progressed much. That is, in Comparative Examples 1 to 6, since the standard deviation of the crystal grain size of the metal substrate 11 is relatively small (less than 2.32 $\mu$m), it is considered that the recrystallization has progressed to a nearly complete state, and the average crystal grain size has become small. On the other hand, in Examples 1 to 18, since the standard deviation of the crystal grain size of the metal substrate 11 is relatively large (2.32 $\mu$m or more), it is considered that the recrystallization has not progressed much, and the average crystal grain size has become large.

In light of the above description, in the present embodiment, an oxide superconducting wire 10 is proposed which includes a tape-shaped metal substrate 11 made of a nickel alloy, an intermediate layer 12 laminated on the metal substrate 11, and an oxide superconducting layer 13 laminated on the intermediate layer 12, in which an average crystal grain size of the metal substrate 11 is 3.08 $\mu$m or more and is equal to or less than a thickness of the metal substrate. The upper limit value of the average crystal grain size of the metal substrate 11 is based on the fact that the average crystal grain size of the metal substrate 11 does not exceed the thickness of the metal substrate 11.

With this configuration, it is possible to achieve an oxide superconducting wire having a high allowable strain amount in $LN_2$, that is, having a low possibility of deterioration of superconducting characteristics even when a tensile stress is applied.

In addition, a standard deviation of a crystal grain size of the metal substrate 11 is in a range of 2.32 to 14.66 $\mu$m. With this configuration, it is possible to achieve an oxide superconducting wire having a metal substrate 11 in which recrystallization has not progressed much and having high tensile resistance.

A technical scope of the present invention is not limited to the above-described embodiment, and various modifications can be made without departing from a spirit of the present invention.

For example, the oxide superconducting wire 10 may not necessarily include the protective layer 14 or the stabilization layer 16.

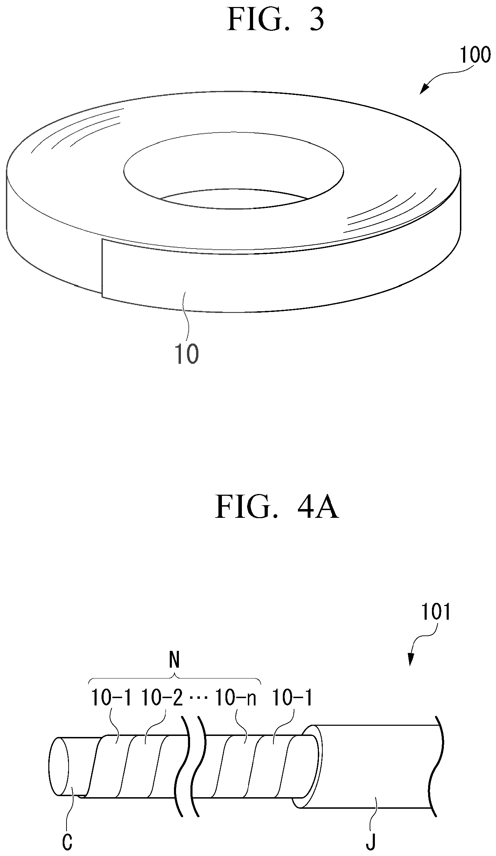

In addition, as shown in FIG. 3, a pancake-type multilayer winding coil (superconducting coil 100) may be formed by winding and laminating the tape-shaped oxide superconducting wire 10 a plurality of times in the thickness direction.

For example, the superconducting coil 100 includes a laminate in which the oxide superconducting wire 10 and a metal tape are alternately laminated, and an impregnated resin layer. The impregnated resin layer impregnates the laminate and covers an outer surface of the laminate. Examples of resin constituting the impregnated resin layer include an epoxy resin and a phenol resin.

The superconducting coil 100 can be manufactured, for example, by a method of forming a coil by winding the oxide superconducting wire 10 coated with a resin (epoxy resin or the like) and a metal tape together to form a coil, and then hardening the resin through heating or the like. As the method of manufacturing the superconducting coil 100, a method of winding the oxide superconducting wire 10 and the metal tape together to form a coil, and then impregnating the coil with the resin under reduced pressure and hardening the resin through heating or the like may be adopted.

Such a superconducting coil 100 can be adopted in a superconducting magnet, a superconducting motor, or the like.

In addition, as shown in FIGS. 4A to 4C, superconductors 101, 102, and 103 may be formed by assembling a plurality of tape-shaped oxide superconducting wires 10. A single oxide superconducting wire 10 can carry a current of several tens to several hundreds of amperes, and bundling a plurality of oxide superconducting wires 10 into superconductors 101, 102, and 103 makes it possible to carry a larger current. Further, the superconductors 101, 102, and 103 can be easily subjected to winding.

As an example of the superconductor, as shown in FIG. 4A, there is a spiral type superconductor 101 in which N tape-shaped oxide superconducting wires 10-1 to 10-n are spirally wound around an outer periphery of a core material C and a coating J is provided on the outer periphery.

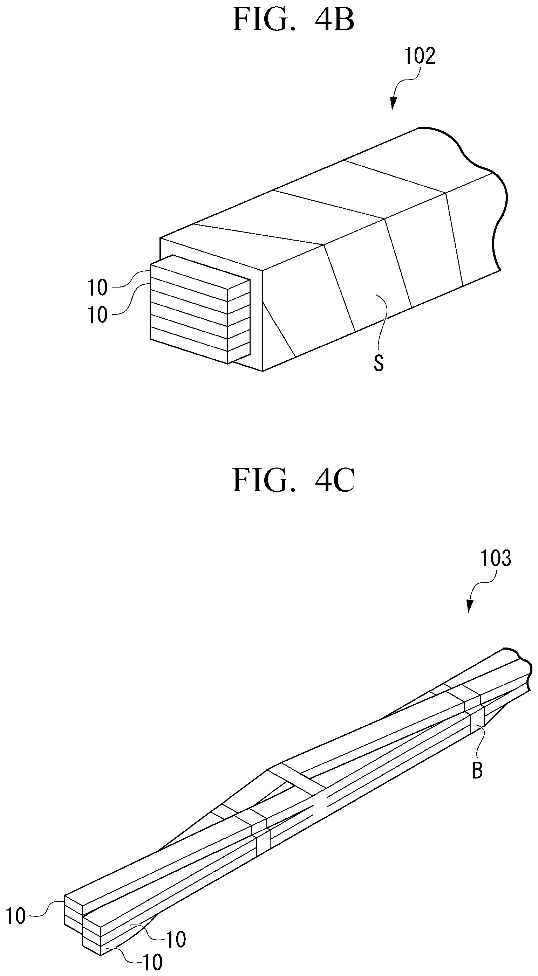

As another example of the superconductor, as shown in FIG. 4B, there is a laminated superconductor 102 in which a plurality of oxide superconducting wires 10 are laminated and an outer periphery of the laminate is coated with a stabilization material S.

As still another example of the superconductor, as shown in FIG. 4C, there is a ROEBEL-type superconductor 103 in which a plurality of oxide superconducting wires 10 bundled at a bundling portion B are patterned in a meandering shape and twisted together.

In addition, it is possible to appropriately replace the constituent elements in the above-described embodiment with well-known constituent elements, and the above-described embodiment and modification examples may be combined as appropriate without departing from the spirit of the present invention.

REFERENCE SIGNS LIST

10 Oxide superconducting wire
11 Metal substrate
12 Intermediate layer
13 Oxide superconducting layer
100 Superconducting coil
101, 102, 103 Superconductor

**Claims**

1. An oxide superconducting wire comprising:

    a tape-shaped metal substrate made of a nickel alloy;
    an intermediate layer laminated on the metal substrate; and
    an oxide superconducting layer laminated on the intermediate layer,
    wherein an average crystal grain size of the metal substrate is 3.08 $\mu$m or more and is equal to or less than a thickness of the metal substrate.

2. The oxide superconducting wire according to Claim 1,
    wherein a standard deviation of a crystal grain size of the metal substrate is in a range of 2.32 to 14.66 $\mu$m.

3. The oxide superconducting wire according to Claim 1 or 2,
    wherein the average crystal grain size is an average value of crystal grain sizes in a cross section of the metal substrate along a longitudinal direction and a thickness direction.

4. The oxide superconducting wire according to any one of Claims 1 to 3,
    wherein the average crystal grain size is an average value of crystal grain sizes measured by a reflection EBSD method.

5. A superconducting coil formed by winding the oxide superconducting wire according to any one of Claims 1 to 4.

**6.** A superconductor formed by assembling a plurality of the oxide superconducting wires according to any one of Claims 1 to 4.

# FIG. 1

# FIG. 2

# FIG. 3

100

10

# FIG. 4A

101

N

10-1 10-2 ··· 10-n   10-1

C

J

# FIG. 4B

# FIG. 4C

## INTERNATIONAL SEARCH REPORT

| International application No. |
|---|
| **PCT/JP2023/038746** |

**A. CLASSIFICATION OF SUBJECT MATTER**

*H01B 12/06*(2006.01)i
FI: H01B12/06

According to International Patent Classification (IPC) or to both national classification and IPC

**B. FIELDS SEARCHED**

Minimum documentation searched (classification system followed by classification symbols)

H01B12/06

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2009-506512 A (LS CABLE LTD.) 12 February 2009 (2009-02-12) paragraphs [0002], [0018]-[0052], fig. 1-13 | 1, 3-4 |
| Y | | 5-6 |
| A | | 2 |
| Y | JP 9-161557 A (HITACHI LTD) 20 June 1997 (1997-06-20) paragraph [0069], fig. 5-6 | 5-6 |

☐ Further documents are listed in the continuation of Box C.    ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **20 December 2023** | **09 January 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/038746**

| Patent document cited in search report | | | Publication date (day/month/year) | Patent family member(s) | Publication date (day/month/year) |
|---|---|---|---|---|---|
| JP | 2009-506512 | A | 12 February 2009 | US 2008/0274896 A1 paragraphs [0002], [0031]-[0061], fig. 1-13 | |
| JP | 9-161557 | A | 20 June 1997 | (Family: none) | |

Form PCT/ISA/210 (patent family annex) (January 2015)

**EP 4 611 007 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022172013 A
- JP 2020166983 A